Europäisches Patentamt

European Patent Office

Office européen des brevets

(19)

(11) Veröffentlichungsnummer: **0 300 993 B1**

(12) # EUROPÄISCHE PATENTSCHRIFT

(45) Veröffentlichungstag der Patentschrift:
16.10.91 Patentblatt 91/42

(51) Int. Cl.⁵: **F16C 33/12, C23C 14/16**

(21) Anmeldenummer: **88890188.1**

(22) Anmeldetag: **18.07.88**

(54) **Hochbelastbares Gleitlager.**

(30) Priorität: **24.07.87 AT 1881/87**

(43) Veröffentlichungstag der Anmeldung:
**25.01.89 Patentblatt 89/04**

(45) Bekanntmachung des Hinweises auf die
Patenterteilung:
**16.10.91 Patentblatt 91/42**

(84) Benannte Vertragsstaaten:
**CH DE ES FR GB IT LI NL SE**

(56) Entgegenhaltungen:
**FR-A- 2 207 193
FR-A- 2 443 926
US-A- 4 471 032
JOURNAL OF VACUUM SCIENCE AND TECH-
NOLOGY, Band 11, Nr. 4, Juli/August 1974, The
American Vacuum Society, New York, US; J.A.
THORNTON: "Influence of apparatus geometry and deposition conditions on the structure
and topography of thick sputtered coatings"**

(73) Patentinhaber: **MIBA Gleitlager
Aktiengesellschaft
Hauptstrasse 3
A-4663 Laakirchen (AT)**

(72) Erfinder: **Koroschetz, Franz, Dr.
Rustonstrasse 5
A-4810 Gmunden (AT)**
Erfinder: **Gärtner, Walter, Dipl.-Ing.
Anton-Schosserstrasse 27
A-4810 Gmunden (AT)**

(74) Vertreter: **Hübscher, Helmut, Dipl.-Ing. et al
Patentanwälte Dipl.-Ing. Gerhard Hübscher
Dipl.-Ing. Helmut Hübscher Dipl.-Ing. Heiner
Hübscher Spittelwiese 7
A-4020 Linz (AT)**

EP 0 300 993 B1

## Beschreibung

Die Erfindung bezieht sich auf ein hochbelastbares Gleitlager mit einer unmittelbar auf einem Träger, insbesondere auf einer Lagermetallschicht, physikalisch im Vakuum aufgebrachten Laufschicht, die aus einem Grundwerkstoff mit fein verteilten, bei Betriebstemperatur im Grundwerkstoff zumindest im wesentlichen unlösbaren Einlagerungen besteht.

Bei herkömmlichen hochbelastbaren Gleitlagern (EP-A-155257) ist zwischen der die Laufflache bildenden, auf Blei- oder Zinnbasis aufgebauten, galvanisch aufgetragenen Laufschicht und der die Laufschicht tragenden Lagermetallschicht eine Zwischenschicht üblicherweise aus Nickel vorgesehen, die bei lagermetallschichten aus einer Aluminiumlegierung eine ausreichende Haftfestigkeit der Laufschicht sichern soll, bei der Verwendung von Bleibronze für die lagermetallschicht jedoch als Diffusionssperre dient, um die Bildung spröder intermetallischer Phasen bei Betriebstemperatur zu vermeiden. Unter hohen Belastungen, beispielsweise durch hohe Schmierfilmspitzendrücke und kleine Schmierspalte, erhöhte Betriebstemperaturen oder verschmutzte und gealterte Schmieröle, kann mit einem vorzeitigen Verschleiß der weichen Laufschicht gerechnet werden, so daß die harte Zwischenschicht zumindest bereichsweise freigelegt werden kann. Außerdem können die tribologischen Eigenschaften der Laufschicht durch eine Zinn- bzw. Kupferverarmung zufolge von sich aufgrund der bekannten Diffusionsphänomene zwischen der Laufschicht und der Nickel-Zwischenschicht bildenden $(CuNi)_xSn_y$-Phasen verschlechtert werden.

Zur Erhöhung der mechanischen Festigkeit und der Warmverschleißfestigkeit ist es aus der DE-C-2853724, welche die im Oberbegriff des Anspruchs 1 aufgeführten Merkmale enthält, bekannt, metallische Gleit- oder Reibschichten aus einem dispersionsverfestigten Verbundwerkstoff durch eine Kathodenzerstäubung aufzubauen, wobei harte nichtmetallische Einlagerungen möglichst gleichmäßig in einem weichen metallischen Grundwerkstoff feinst verteilt werden. Abgesehen davon, daß diese dispersionsverfestigten Verbundwerkstoffe bei ihrem Einsatz als Laufschicht eines Gleitlagers wiederum das Vorsehen einer Zwischenschicht empfehlenswert machen, können solche Laufschichten aufgrund ihrer höheren Härte die weichere Welle angreifen.

Schließlich ist es bekannt (J. A. Thornton "Influence of apparatus geometry and deposition conditions on the structure and topography of thick sputtered coatings" J. Vac. Sci. Technol., Vol. 11 No. 4, July/Aug. 1974, p. 666-670), daß der auf einen Träger durch eine Kathodenzerstäubung aufzubringende Werkstoff unter bestimmten Verfahrensbedingungen in Abhängigkeit vom gewählten Gasdruck und dem Verhältnis der Trägertemperatur zum Schmelzpunkt des aufzubringenden Werkstoffes auf dem Träger in Stengelform mit einer zur Trägeroberfläche senkrechten Vorzugsausrichtung kristallisiert.

Der Erfindung liegt somit die Aufgabe zugrunde, ein hochbelastbares Gleitlager zu schaffen, das trotz einer vergleichsweise weichen Laufschicht über die geforderte Standzeit weitgehend verschleißfrei und störungsunempfindlich bleibt und eine Laufflache mit einer minimalen Verreibneigung bildet.

Ausgehend von einem hochbelastbaren Gleitlager der eingangs geschilderten Art löst die Erfindung die gestellte Aufgabe dadurch, daß die Einlagerungen ausschließlich eine geringere Härte als der Grundwerkstoff und einen mittleren Korndurchmesser kleiner als 3 μm aufweisen, daß der Grundwerkstoff der Laufschicht in Stengelform mit einer zur Laufflache senkrechten Vorzugsausrichtung kristallisiert ist und daß die Hauptlegierungsbestandteile des Trägers und der Laufschicht Metalle sind, die bei Betriebstemperatur intermetallische Verbindungen ausschließen.

Durch die stengelförmigen, im wesentlichen senkrecht auf die Laufflache ausgerichteten Kristallite des Grundwerkstoffes der Laufschicht wird zunächst die Abriebfestigkeit und die Druckfestigkeit der Laufschicht erhöht, ohne deren Härte zu beeinflussen, die durch die ausschließlich weicheren Einlagerungen und die Kristallitengröße des Grundwerkstoffes mitbestimmt wird. Aufgrund der geforderten feinen Verteilung der weicheren Einlagerungen im Grundwerkstoff der Laufschicht und der nach oben begrenzten Korngröße, an die auch der Durchmesser der stengelförmigen Kristallite des Grundwerkstoffes angepaßt sein sollen, stellt sich selbst in eng begrenzten örtlichen Bereichen eine Mischwirkung zwischen dem Grundwerkstoff und den Einlagerungen ein, so daß sich eine sehr geringe Affinität zum Wellenwerkstoff und damit eine sehr geringe Verreibneigung ergibt. Die feine Verteilung der Einlagerungen, die einen mittleren Korndurchmesser von höchstens 3 μm und einen Schmelzpunkt über der maximal auftretenden Betriebstemperatur aufweisen, stellt auch bei höheren Betriebstemperaturen von 170 bis 200°C eine vorteilhafte Dauerfestigkeit sicher.

Da außerdem die Hauptlegierungsbestandteile des im allgemeinen eine Lagermetallschicht bildenden Trägers und der Laufschicht bei Betriebstemperatur intermetallische Verbindungen ausschließende Metalle sind, kann eine Zwischenschicht zwischen der Laufschicht und dem Träger als Diffusionssperre entfallen. Eine solche Zwischenschicht ist aber auch nicht zur Haftvermittlung erforderlich, weil durch die Ausrichtung der stengelförmigen Kristallite des Grundwerkstoffes senkrecht zur Laufflache und damit senkrecht zur Oberfläche des Trägers sich bei einer entsprechenden, rückstandsfreien Reinigung der Oberfläche des Trägers eine gute Verkrallung zwischen der Laufschicht und dem Träger durch die beim Aufbau der Laufschicht senkrecht in die Oberfläche des Trägers eindringenden Atome einstellt. Es kann daher die Zwischenschicht, ohne die sonst eintretenden Nachteile in Kauf nehmen zu müssen, entfallen und der damit verbundene Vorteil genützt werden, daß bei einem vollkommenen Verschleiß der Laufschicht die Notlaufeigenschaften der als Träger dienenden Lagermetallschicht zum Tragen kommen.

Um intermetallische Verbindungen zwischen den Hauptlegierungsbestandteilen des Trägers und der Laufschicht in einfacher Weise ausschließen zu können, kann der Hauptlegierungsbestandteil des Grundwerkstoffes der Laufschicht dem des Trägers entsprechen. Wegen der bei Betriebstemperatur im Grundwerkstoff unlöslichen Einlagerungen ist auch eine Wechselwirkung zwischen den weicheren Einlagerungen der Laufschicht und der Lagermetallschicht als Träger auszuschließen.

Bei unterschiedlichen Hauptlegierungsbestandteilen des Trägers und der Laufschicht können intermetallische Verbindungen bei der Betriebstemperatur dann mit Sicherheit vermieden werden, wenn die Schmelzpunkte der Hauptlegierungsbestandteile zumindest der dreifachen Betriebstemperatur entsprechen, weil in diesem Fall die Bildungsenergie für solche intermetallische Phasen bei der Betriebstemperatur nicht zur Verfügung steht.

Ist in weiterer Ausbildung der Erfindung die Grenzflächenzone der Laufschicht zum Träger hin zumindest im wesentlichen frei von Einlagerungen, so werden auch sich störend bemerkbar machende Diffusionsphänomene mit einer Beteiligung der Einlagerungen im Grundwerkstoff der Laufschicht wirksam vermieden. Die Dicke dieser Grenzflächenzone kann z.B. 0,01 bis 0,1 µm betragen, spielt aber wegen der Unlösbarkeit der Einlagerungen im Grundwerkstoff bei den gegebenen Betriebstemperaturen keine wesentliche Rolle.

Reicht in Sonderfällen die Festigkeit der die Laufschicht tragenden Lagermetallschicht nicht zur Aufnahme der auftretenden Belastungen auf, so kann die Laufschicht auch unmittelbar auf die dann als Träger dienende, stählerne Stützschale aufgebracht werden, weil aufgrund der geringen Verschleißanfälligkeit der Laufschicht die Gefahr eines bereichsweisen Freilegens der stählernen Stützschale gering bleibt.

Den gestellten Forderungen genügen Laufschichten bzw. Träger mit einem Hauptlegierungsbestandteil aus Aluminium, Kupfer, Eisen, Nickel oder Silber. Obwohl für die weichen Einlagerungen im Grundwerkstoff der Laufschicht auch Kunststoffe Verwendung finden könnten, ergeben sich besonders vorteilhafte Bedingungen, wenn die weicheren Einlagerungen aus einem Metall, wie Zinn, Blei oder Wismut, bestehen, weil bei metallischen Einlagerungen eine bessere Wärmeableitung sichergestellt werden kann.

Der Anteil der weicheren Einlagerungen am Volumen der Laufschicht wird nach unten durch die Mindestanforderung im Hinblick auf die Verreibneigung der Laufschicht und nach oben durch die geforderte Mindestfestigkeit begrenzt. Macht der Volumsanteil der weicheren Einlagerungen 5 bis 45% aus, so kann den üblichen Belastungen unter Mischreibung hinsichtlich der Verreibneigung zufriedenstellend entsprochen werden. Bezüglich der Festigkeitsverhältnisse ist allerdings die Dichte des Hauptlegierungsbestandteiles des Grundwerkstoffs der Laufschicht zu berücksichtigen. Bei einer Laufschicht mit Aluminium als Hauptlegierungsbestandteil sollen daher die weicheren Einlagerungen höchstens 20 Vol% betragen. Wird die Laufschicht auf der Basis von Kupfer oder Silber aufgebaut, so können die weicheren Einlagerungen vorteilhaft 15 bis 40 Vol% ausmachen.

Entspricht die Härte der Laufschicht zumindest im wesentlichen jener des Trägers, so kann nicht nur eine gute Tragfähigkeit für das Gleitlager sichergestellt, sondern auch das Versagensrisiko beim verschleißbedingten Übergang von der Laufschicht auf die den Träger bildende Lagermetallschicht verringert werden.

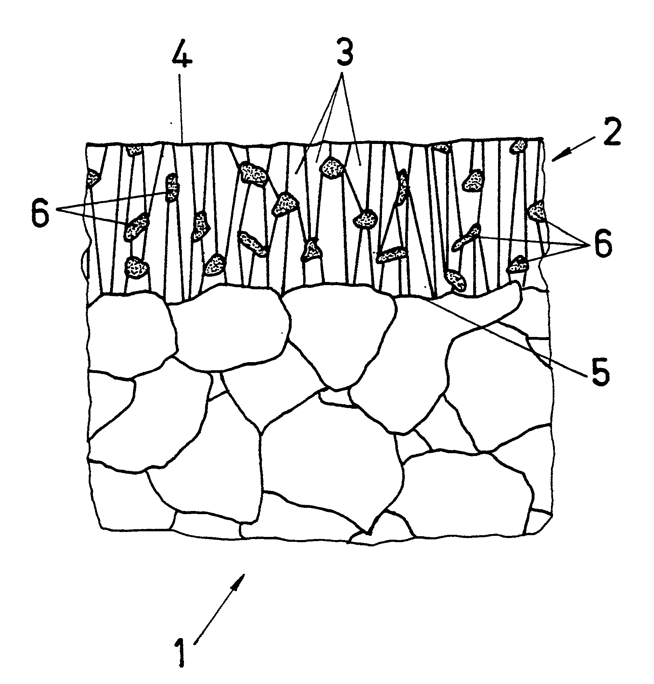

In der Zeichnung ist der Erfindungsgegenstand beispielsweise dargestellt, und zwar wird ein erfindungsgemäßes Gleitlager in einem schematischen Schnittbild durch die auf einem Träger aufgebrachte Laufschicht gezeigt.

Das dargestellte Gleitlager besteht im wesentlichen aus einer gegebenenfalls auf einer nicht dargestellten stählernen Stützschale aufgebrachten Lagermetallschicht als Träger 1 und einer auf dies Lagermetallschicht physikalisch im Vakuum aufgebrachten Laufschicht 2, die aus einem Grundwerkstoff mit stengelförmigen Kristalliten 3 aufgebaut ist, die im wesentlichen senkrecht zur Lauffläche 4 bzw. zur Grenzfläche 5 zwischen der Laufschicht 2 und der Lagermetallschicht 1 ausgerichtet sind. In diesem stengelförmig kristallisierten Grundwerkstoff sind ausschließlich weichere Einlagerungen 6 mit einem mittleren Korndurchmesser von höchstens 3 µm fein verteilt eingebettet, so daß auch in eng begrenzten örtlichen Bereichen die tribologischen Eigenschaften der Laufschicht nicht vom Grundwerkstoff oder den Einlagerungen 6 allein, sondern sowohl vom Grundwerkstoff als auch von den Einlagerungen bestimmt werden. Die Stengelform der Kristallite 3 wird durch eine zur Grenzfläche 5 senkrechte Auftragsrichtung der Atome erzielt, und zwar unter Einhaltung bestimmter Temperatur- und Druckverhältnisse, wie dies beim Kathodenzerstäuben an sich bekannt ist. Das Kathodenzerstäuben erfolgt beispielsweise bei einer Temperatur des Targetmaterials von etwa 80°C und einem Argon-Druck von etwa $2.10^{-3}$ mbar, wobei die koaxial zur Stabkathode angeordnete Lagermetallschicht auf einer konstanten Temperatur gehalten wird, die z.B. der halben absoluten Temperatur des Schmelzpunktes des Grundwerkstoffes der Laufschicht entspricht.

Vor dieser Beschichtung der Lagermetallschicht 1 mit der Laufschicht ist die Oberfläche der Lagermetallschicht jedoch rückstandfrei zu reinigen und z.B. durch Ionenbeschuß in einer Gasentladung die Oberflächenoxidschicht zu entfernen bzw. die Lagermetalloberfläche zu aktivieren, um eine gewünschte Haftfestigkeit zwischen der Laufschicht und der Lagermetallschicht sicherzustellen.

Soll beispielsweise auf einer AlZn4, 5SiCuPbMg-Lagermetallschicht 1 eine Laufschicht 2 aus AlPb30 mit Hilfe des beschriebenen Kathodenzerstäubungsverfahrens aufgetragen werden, so können auf die Kathode entsprechende Ringe aus Blei und Aluminium in einer geeigneten Reihenfolge aufgebracht werden, wobei durch eine axiale Relativbewegung zwischen der Kathode und der Lagermetallschicht während der Zerstäubung das Aluminium auf der Lagermetallschicht 1 mit einer zur Lauffläche 4 senkrechten Vorzugsausrichtung stengelförmig kristallisiert und gleichzeitig das weichere Blei in feinster Verteilung in diesem Grundwerkstoff eingelagert wird, und zwar mit einem Volumsanteil von etwa 9,5%. Der Durchmesser der stengelförmigen Kristallite 3 entspricht dabei etwa dem mitteleren Korndurchmesser der Einlagerungen 6 und wird vom Druck und den Temperaturverhältnissen während des Zerstäubungsvorganges bestimmt. Die Dicke der Laufschicht soll zwischen 5 und 30 µm vorzugsweise 8 bis 16 µm betragen. Wird der Durchmesser der Einlagerungen größer als die halbe Schichtdicke, so sinkt die Festigkeit sehr rasch ab. Da die Verreibneigung um so kleiner wird, je feiner die Einlagerungen im Grundwerkstoff verteilt sind, ist ein vergleichsweise geringer Durchmesser sowohl der Einlagerungen 6 als auch der Kristallite 3 anzustreben. Besonders günstige Verhältnisse werden bei mittleren Durchmessern zwischen 0,1 und 1,5 µm erzielt.

Soll bei einem anderen Ausführungsbeispiel eine AlSn20-Laufschicht auf einer AlZn4, 5MgZr-Lagermetallschicht aufgetragen werden, so können für die Kathodenzerstäubung Targetringe aus AlSn20 gegossen werden. Der Anteil der weicheren Zinneinlagerungen macht bei einer solchen Laufschicht ca. 8,5 Vol% aus. Diese Laufschicht ist bei korrosiven Schmierölen einer Laufschicht aus AlPb30 vorzuziehen.

Für besondere Belastungen kann die Lagermetallschicht 1 auf der Basis von Aluminium durch eine gegossene Bleibronze CuPb22Sn ersetzt werden, ohne daß eine als Diffusionssperre erforderliche Zwischenschicht erforderlich wird, wenn dafür gesorgt ist, daß sich in der Grenzflächenzone der Laufschicht 2 im wesentlichen keine weicheren Einlagerungen befinden. Diese Forderung kann in einfacher Weise durch eine entsprechende Anordnung der Targetwerkstoffe auf der Kathode bei gleichzeitiger axialer Relativbewegung von der Kathode und der Lagermetallschicht erreicht werden. Die Dicke der von Einlagerungen freien Grenzzone spielt dabei wegen der Unlöslichkeit der Einlagerungen im Grundwerkstoff der Lauschicht bei den gegebenen Betriebstemperaturen eine untergeordnete Rolle.

Soll ein besonders verreibunempfindliches und hochbelastbares Gleitlager hergestellt werden, so kann eine AgPb35-Laufschicht auf einer gegossenen Bleibronze CuPb22Sn aufgetragen werden, wobei das Silber und das Blei wieder in gesonderten Ringen auf die Kathode aufgebracht werden können. Der Volumstanteil der weicheren Bleieinlagerungen beträgt in diesem Falle etwa 33 Vol%.

Für einen hohen Verschleißwiderstand gegen abrasive Teilchen im Schmieröl eignet sich insbesondere eine Laufschicht aus CuPb30 auf einer AlZn4,5- oder CuPb22Sn-Lagermetallschicht. Für die Kathodenzerstäubung können Targetringe aus CuPb30 gegossen und auf die Kathode aufgebracht werden. Der Bleianteil in der Laufschicht macht dabei etwa 25 Vol% aus.

An Stelle von Blei kann auch Wismut als weiche Einlagerung in einem Grundwerkstoff aus Silber oder Kupfer eingesetzt werden.

Die Erfindung ist selbstverständlich nicht auf die beschriebenen Ausführungsbeispiele beschränkt. So könnte die Laufschicht auch durch ein anderes Verfahren als durch eine Kathodenzerstäubung auf die Lagermetallschicht aufgetragen werden, beispielsweise durch ein Ionenplattieren, weil es ja vor allem auf die beschriebene stengelförmige Ausbildung der Kristallite des Grundwerkstoffes der Laufschicht und die darin fein verteilten weicheren Einlagerungen ankommt und nicht auf das Herstellungsverfahren. Außerdem könnte für besondere Belastungsverhältnisse auf eine Lagermetallschicht verzichtet und die Laufschicht unmittelbar auf die stählerne Stützschale als Träger 1 aufgebracht werden.

**Patentansprüche**

1. Hochbelastbares Gleitlager mit einer unmittelbar auf einem Träger, insbesondere auf einer Lagermetallschicht (1), physikalisch im Vakuum aufgebrachten Laufschicht (2), die aus einem Grundwerkstoff mit fein verteilten, bei Betriebstemperatur im Grundwerkstoff zumindest im wesentlichen unlösbaren Einlagerungen (6) besteht, dadurch gekennzeichnet, daß die Einlagerungen (6) ausschließlich eine geringere Härte als der Grundwerkstoff und einem mittleren Korndurchmesser kleiner als 3µm aufweisen, daß der Grundwerkstoff der Laufschicht (2) in Stengelform mit einer zur Lauffläche (4) senkrechten Vorzugsausrichtung kristallisiert ist und daß die Hauptlegierungsbestandteile des Trägers (1) und der Laufschicht (2) Metalle sind, die bei Betriebstemperatur intermetallische Verbindungen ausschließen.

2. Gleitlager nach Anspruch 1, dadurch gekennzeichnet, daß der Hauptlegierungsbestandteil des Grundwerkstoffes der Laufschicht (2) dem des Trägers (1) entspricht.

3. Gleitlager nach Anspruch 1, dadurch gekennzeichnet, daß bei unterschiedlichen Hauptlegierungsbestandteilen des Trägers (1) und der Laufschicht (2) die Schmelzpunkte der Hauptlegierungsbestandteile zumindest der dreifachen Betriebstemperatur entsprechen.

4. Gleitlager nach Anspruch 3, dadurch gekennzeichnet, daß die Grenzflächenzone der Laufschicht (2) zum Träger (1) hin zumindest im wesentlichen frei von Einlagerungen (6) ist.

5. Gleitlager nach einem der Ansprüche 1 bis 4, dadurch gekennzeichnet, daß der Träger (1) aus einer stählernen Stützschale besteht.

6. Gleitlager nach einem der Ansprüche 1 bis 5, dadurch gekennzeichnet, daß die Hauptlegierungsbestandteile der Laufschicht (2) bzw. des Trägers (1) aus Aluminium, Kupfer, Eisen, Nickel oder Silber bestehen.

7. Gleitlager nach einem der Ansprüche 1 bis 6, dadurch gekennzeichnet, daß die weicheren Einlagerungen (6) aus Zinn, Blei oder Wismut bestehen.

8. Gleitlager nach einem der Ansprüche 1 bis 7, dadurch gekennzeichnet, daß der Volumsanteil der weicheren Einlagerungen (6) an der Laufschicht (2) 5 bis 45% ausmacht.

9. Gleitlager nach Anspruch 8, dadurch gekennzeichnet, daß bei einer Laufschicht (2) mit Aluminium als Hauptlegierungsbestandteil die weicheren Einlagerungen (6) höchstens 20 Vol% betragen.

10. Gleitlager nach Anspruch 8, dadurch gekennzeichnet, daß bei einer Laufschicht (2) mit Kupfer oder Silber als Hauptlegierungsbestandteil die weicheren Einlagerungen (6) 15 bis 40 Vol% ausmachen.

11. Gleitlager nach einem der Ansprüche 1 bis 10, dadurch gekennzeichnet, daß die Härte der Laufschicht (2) zumindest im wesentlichen jener des Trägers (1) entspricht.

## Claims

1. A heavy duty plain bearing having a running layer (2) which has been vacuum coated on a substrate, more particularly a bearing metal layer (1) and which consists of a parent substance having finely divided inclusions (6) which are at least substantially insoluble in the parent substance at the working temperature, characterised in that the inclusions (6) have exclusively a hardness less than that of the parent substance and an average grain size of less than 3 μm, the parent substance of the running layer (2) is crystallised in stalk form with a preferred orientation perpendicular to the running surface (4), and the main alloy constituents of the substrate (1) and running layer (2) are metals which preclude intermetallic compounds at the working temperature.

2. A plain bearing according to claim 1, characterised in that the main alloy constituent of the parent substance of the running layer (2) corresponds to that of the substrate (1).

3. A plain bearing according to claim 1, characterised in that if the main alloy constituents of the substrate (1) and running layer (2) are different from one another, the melting points of the main alloy constituents are at least three times the working temperature.

4. A plain bearing according to claim 3, characterised in that the boundary surface zone of the running layer (2) is at least substantially free from inclusions (6) towards the substrate (1),

5. A plain bearing according to any of claims 1 to 4, characterised in that the substrate (1) consists of a steel supporting shell.

6. A plain bearing according to any of claims 1 to 5, characterised in that the main alloy constituents of the running layer (2) or substrate (1) consist of aluminium or copper or iron or nickel or silver.

7. A plain bearing according to any of claims 1 to 6, characterised in that the relatively soft inclusions (6) consist of tin or lead or bismuth.

8. A plain bearing according to any of claims 1 to 7, characterised in that the volume proportion of the relatively soft inclusions (6) makes up from 5 to 45% of the running layer (2).

9. A plain bearing according to claim 8, characterised in that in the case of a running layer (2) having aluminium as its main alloy constituent the relatively soft inclusions (6) amount to at most 20 volume %.

10. A plain bearing according to claim 8, characterised in that in the case of a running layer (2) having copper or silver as its main alloy constituent the relatively soft inclusions (6) make up from 15 to 40 volume %.

11. A plain bearing according to any of claims 1 to 10, characterised in that the hardness of the running layer (2) corresponds at least substantially to the hardness of the substrate (1).

## Revendications

1. Palier lisse pour fortes charges comprenant une couche de portée (2) déposée directement par un procédé physique dans le vide, sur un support, en particulier sur une couche de métal antifriction (1), et qui est composée d'une matière de base chargée d'inclusions (6) finement réparties, et qui sont au moins sensiblement insolubles dans la matière de base à la température de service, caractérisé en ce que les inclusions (6) présentent exclusivement une dureté inférieure à celle de la matière de base et un diamètre de grain moyen inférieur à 3 μm, en ce que

la matière de base de la couche de portée (2) est cristallisée en aiguilles possédant une orientation préférentielle perpendiculaire à la surface de portée (4), et en ce que les principaux constituants d'alliage du support (1) et de la couche de portée (2) sont des métaux qui excluent toute combinaison intermétallique à la température de service.

2. Palier lisse selon la revendication 1, caractérisé en ce que le principal constituant d'alliage de la matière de base de la couche de portée (2) correspond à celui du support (1).

3. Palier lisse selon la revendication 1, caractérisé en ce que, dans le cas où les principaux constituants d'alliage du support (1) et de la couche de portée (2) sont différents, les points de fusion des principaux constituants d'alliage correspondent au moins à trois fois la température de service.

4. Palier lisse selon la revendication 3, caractérisé en ce que la zone de surface limite qui sépare la couche de portée (2) du support (1) est au moins sensiblement exempte d'inclusions (6).

5. Palier lisse selon une des revendications 1 à 4, caractérisé en ce que le support (1) est constitué par une coquille porteuse en acier.

6. Palier lisse selon une des revendications 1 à 5, caractérisé en ce que les principaux constituants d'alliage de la couche de portée (2) et du support (1) sont composés d'aluminium, de cuivre, de fer, de nickel ou d'argent.

7. Palier lisse selon une des revendications 1 à 6, caractérisé en ce que les inclusions plus tendres (6) sont composées d'étain, de plomb ou de bismuth.

8. Palier lisse selon une des revendications 1 à 7, caractérisé en ce que la proportion en volume des inclusions plus tendres (6) représente 5 à 45% de la couche de portée (2).

9. Palier lisse selon la revendication 8, caractérisé en ce que, dans le cas d'une couche de portée (2) dans laquelle l'aluminium est le principal composant d'alliage, les inclusions plus tendres (6) représentent au maximum 20% en volume.

10. Palier lisse selon la revendication 8, caractérisé en ce que, dans le cas d'une couche de portée (2) dans laquelle le cuivre ou l'argent est le principal constituant d'alliage, les inclusions plus tendres (6) représentent 15 à 40% en volume.

11. Palier lisse selon une des revendications 1 à 10, caractérisé en ce que la dureté de la couche de portée (2) correspond au moins sensiblement à celle du support (1).